## Europäisches Patentamt
## European Patent Office
## Office européen des brevets

(19)

(11) Veröffentlichungsnummer: **0 385 225**
**A2**

(12) **EUROPÄISCHE PATENTANMELDUNG**

(21) Anmeldenummer: **90103180.7**

(22) Anmeldetag: **20.02.90**

(51) Int. Cl.5: **C08G 12/42, C08G 12/32, D21H 17/51, D21H 27/12, B32B 27/42**

(30) Priorität: **25.02.89 DE 3905913**

(43) Veröffentlichungstag der Anmeldung:
**05.09.90 Patentblatt 90/36**

(84) Benannte Vertragsstaaten:
**AT BE CH DE DK ES FR GB IT LI NL SE**

(71) Anmelder: **BASF Aktiengesellschaft**
**Carl-Bosch-Strasse 38**
**D-6700 Ludwigshafen(DE)**

(72) Erfinder: **Busse, Gerd**
**Thomas-Mann-Strasse 28**
**D-6704 Mutterstadt(DE)**
Erfinder: **Decher, Jakob**
**Otto-Karch-Strasse 12**
**D-6712 Bobenheim-Roxheim(DE)**
Erfinder: **Eisele, Wolfgang, Dr.**
**Niedererdstrasse 103**
**D-6700 Ludwigshafen(DE)**
Erfinder: **Haeussler, Edgar**
**Friedhofstrasse 9**
**D-6737 Böhl-Iggelheim(DE)**
Erfinder: **Wittmann, Otto**
**Max-Beckmann-Strasse 13 b**
**D-6710 Frankenthal(DE)**

(54) **Aminoharz-Lösungen mit geringer elektrischer Leitfähigkeit.**

(57) Die vorliegende Erfindung betrifft Aminoharz-Lösungen mit einer elektrischen Leitfähigkeit < 100 μS/cm zum Imprägnieren von Papier, erhältlich durch

A) Methylolierung von Melamin mit wäßrigem Formaldehyd im Molverhältnis 1 : 2 bis 5 in Gegenwart eines tertiären organischen Amins bei einem pH-Wert von 7 bis 12

B) Veretherung mit einem molaren Überschuß, bezogen auf die Methylolgruppen, eines $C_1$- bis $C_4$-Alkohols in Gegenwart einer ggf. substituierten organischen Dicarbonsäure und/oder Polycarbonsäure bei einem pH-Wert von 4 bis 4,5.

C) Neutralisation des Reaktionsgemisches mit einer anorganischen Base und Abdestillation der flüchtigen Bestandteile bis auf einen Wassergehalt von < 6 Gew.%, bezogen auf das Reaktionsgemisch,

D) Zugabe eines $C_1$- bis $C_4$-Alkohols bis zu einem Feststoffgehalt, bezogen auf Aminoharz-Lösungen, von 40 bis 90 Gew.% und Entfernen von unlöslichen Bestandteilen durch Filtration.

EP 0 385 225 A2

## Aminoharz-Lösungen mit geringer elektrischer Leitfähigkeit

Die vorliegende Erfindung betrifft Aminoharz-Lösungen mit einer elektrischen Leitfähigkeit < 100 µS/cm, die erhältlich sind durch Methylolierung von Melamin mit Formaldehyd mit anschließender Veretherung, Abdestillation von flüchtigen Bestandteilen aus dem neutralisierten Reaktionsgemisch bis auf einen geringen Wassergehalt, Zugabe eines Alkohols und Entfernen der unlöslichen Bestandteile durch Filtration.

Zur Herstellung von elektrischen Leitertafeln werden mit Harzen imprägnierte Papiere, die sogenannten Hartpapiere verwendet. Zum Tränken dieser Papiere wurden bisher Lösungen von Phenol- oder Kresolresolharzen verwendet. Die mit alkoholischer oder alkoholisch wäßriger Lösung getränkten Papiere wurden einem Trocknungs- und Härtungsvorgang unterzogen.

Die mechanischen Eigenschaften der Papiere werden durch den Kondensationsgrad der Resole oder durch Imprägnierungen in einem oder mehreren Schritten beeinflußt. Den Imprägnierlösungen können auch Weichmacher zugesetzt werden, um die Biegsamkeit der Papiere zu verbessern und Sprödigkeit und Risse zu vermeiden. Da die Resol-Harzlösungen arm an oder frei von Ionen sind, eignen sie sich zur Herstellung der Hartpapiere, die eine geringe elektrische Leitfähigkeit bzw. einen hohen elektrischen Widerstand aufweisen müssen.

Hochwertige Hartpapiere werden mit geeigneten Flammschutzmitteln flammfest oder brandbeständig ausgerüstet. Dies sind bromierte oder chlorierte Verbindungen. Werden in der Resolharzsynthese chlorierte oder bromierte Phenole eingesetzt, resultiert auch eine Flammschutzwirkung. Dies hat aber zur Folge, daß unter Bedingungen der Pyrolyse, z.B. einem von außen auf das imprägnierte Material einwirkenden Brand, halogenhaltige toxische Pyrolyseprodukte entstehen können, was unter Umweltgesichtspunkten nicht tolerierbar ist. Nicht flammfest ausgerüstete, nur mit Phenol- und/oder Kresolresolharzen imprägnierte Hartpapiere brennen zu leicht.

Veretherte Methylolmelamin-Harze sind bekannt und sind beispielsweise im Houben-Weyl, Methoden der Organischen Chemie, Band XIV/2, Seiten 361 bis 368 sowie im Ullmann Encyklopädie der Technischen Chemie, 1953, Band 3, 487 bis 489, beschrieben. Da die Veretherung in Gegenwart von sauren Katalysatoren durchgeführt wird, müssen diese nach Neutralisation abgetrennt werden, was bisher nur unvollständig gelang, so daß beim Lagern der Produkte unerwünschte Trübungen auftraten und die nicht entfernten Elektrolyte eine starke Verringerung des elektrischen Widerstandes und der Kriechstromfestigkeit der mit diesen Aminoplastharzen hergestellten Formkörpern hervorriefen.

In der US-PS 25 29 856 wird ein Verfahren zur Herstellung veretherter Methylolmelamin-Harze beschrieben durch Umsetzung von Methanol mit angesäuertem Polymethylol-Melamin und Entwässerung nach Neutralisation. Auch diese Harze sind nicht elektrolytfrei.

Nach der DE-PS 26 03 768 gelangt man zu elektrolytfreien Aminoplasten, wenn man Methylolaminotriazine mit speziellen Glykolderivaten in Abwesenheit von Säuren und Alkalien kondensiert. Nach diesem Verfahren lassen sich allerdings nur sehr spezielle Aminoplaste herstellen.

Aufgabe der vorliegenden Erfindung war es, wäßrige Aminoharz-Lösungen mit niedriger elektrischer Leitfähigkeit zu entwickeln zur Imprägnierung von Substraten, die sich zu Schichtpreßstoffen verpressen lassen, die gute technische Eigenschaften aufweisen, die brandfest sind und für die Herstellung elektrischer Leitertafeln geeignet sind.

Gelöst wurde die Aufgabe durch Metylolierung und Veretherung von Melamin mit nachfolgender Abtrennung von unlöslichen Bestandteilen durch bestimmte Verfahrensmaßnahmen.

Gegenstand der vorliegenden Erfindung sind Aminoharz-Lösungen mit einer elektrischen Leitfähigkeit < 100 µS/cm zum Imprägnieren von Papier, die erhältlich sind durch

A) Methylolierung von Melamin mit wäßrigem Formaldehyd im Molverhältnis 1 : 2 bis 5 in Gegenwart eines tertiären organischen Amins bei einem pH-Wert von 8 bis 12,

B) Veretherung mit einem molaren Überschuß, bezogen auf die Methylolgruppen, eines $C_1$- bis $C_4$-Alkohols in Gegenwart einer ggf. substituierten Dicarbonsäure und/oder Polycarbonsäure bei einem pH-Wert von 3 bis 6,

C) Neutralisation des Reaktionsgemisches mit einer anorganischen Base und Abdestillation der flüchtigen Bestandteile bis auf einen Wassergehalt von < 6 Gew.%, bezogen auf das Reaktionsgemisch,

D) Zugabe eines $C_1$- bis $C_4$-Alkohols bis zu einem Feststoffgehalt, bezogen auf Aminoharz, von 40 bis 90 Gew.% und Entfernen von unlöslichen Bestandteilen durch Filtration.

Die vorliegende Erfindung bezieht sich weiterhin auf die Verwendung der Aminoharz-Lösungen zur Herstellung von Schichtpreßstoffen, die Schichtpreßstoffe selbst, die Verwendung dieser Schichtpreßstoffe zur Herstellung von elektrischen Leitertafeln sowie auf die elektrischen Leitertafeln selbst.

Zu den Aufbaukomponenten und Reaktionsstufen ist im einzelnen folgendes auszuführen:

In der Stufe (A) wird die Methylolierung von Melamin mit wäßrigem Formaldehyd in einem Molverhältnis von 1 : 2 bis 5, bevorzugt 1 : 3,5 bis 4 in Gegenwart eines organischen tertiären Amins bei einem pH-Wert von 7 bis 12, bevorzugt 6,8 bis 7,2 durchgeführt.

Geeignete organische tertiäre Amine sind aliphatische Mono-, Di- oder Polyamine, die gegebenenfalls substituiert sein können, mit 3 bis 20 C-Atomen wie beispielsweise Trimethylamin, Triethylamin, Tri-n-propylamin, Triisopropylamin, Tributylamin, Triisobutylamin und Hexamethylentetramin. Auch Aminoalkohole wie Triethanolamin, Triisopropanolamin und Diethylethanolamin sind geeignet. Bevorzugt werden Triethanolamin, Triethylamin und Hexamethylentetramin verwendet. Es können auch Gemische der genannten Amine verwendet werden.

In der Stufe (B) wird mit einer Di- oder Polycarbonsäure, die substituiert sein kann, ein pH-Wert von 3 bis 6, vorzugsweise von 3,5 bis 5 und insbesondere 4 bis 4,5 eingestellt. Geeignete Dicarbonsäuren sind beispielsweise Oxalsäure, Maleinsäure, Malonsäure, Bernsteinsäure, Adipinsäure und Phthalsäure. Als substituierte Dicarbonsäuren können Dimethylmalonsäure, Hydroxybernsteinsäure oder Weinsäure verwendet werden.

Als ggf. substituierte Polycarbonsäure ist beispielsweise Citronensäure, geeignet.

Bevorzugt werden Oxalsäure, Malonsäure und Citronensäure verwendet.

Bei diesem mit den organischen Säuren eingestellten pH-Wert wird mit einem molaren Überschuß, bezogen auf die Methylolgruppen des methylolierten Melamins, eines $C_1$- bis $C_4$-Alkohols bei üblichen Temperaturen von z.B. 50 bis 60°C verethert.

Geeignete $C_1$- bis $C_4$-Alkohole sind beispielsweise Methanol, Ethanol, n- und i-Propanol sowie n-Butanol. Bevorzugt wird Methanol verwendet.

Nach der Veretherungsstufe wird in (C) das Reaktionsgemisch mit einer anorganischen Base neutralisiert und von den flüchtigen Bestandteilen durch Abdestillation befreit bis der Wassergehalt, bezogen auf das Reaktionsgemisch, < 10 Gew.% bevorzugt < 6 Gew.% beträgt.

Als anorganische Basen sind Alkali- und/oder Erdalkalihydroxide wie Natriumhydroxid, Kaliumhydroxid, Calciumhydroxid und Bariumhydroxid geeignet. Bevorzugt wird Natriumhydroxid verwendet.

Das Abdestillieren der flüchtigen Bestandteile wie Amin, Alkohole und Wasser kann sowohl bei Normaldruck als auch im Vakuum bei Drücken von 50 bis 100 mbar erfolgen. Bewährt hat sich eine stufenweise Destillation beginnend bei Normaldruck mit anschließender Destillation bei Drücken von 50 bis 100 mbar.

In der Stufe (D) wird soviel eines $C_1$- bis $C_4$-Alkoholes zugegeben, daß ein Feststoffgehalt, bezogen auf Aminoharz-Lösungen von 40 bis 90 Gew.%, bevorzugt 60 bis 65 Gew.% resultiert. Geeignete $C_1$- bis $C_4$-Alkohole sind Methanol, Ethanol und Propanol. Bevorzugt wird Methanol verwendet. Der unlösliche Niederschlag der Aminoharz-Lösung wird durch Filtration z.B. über einen Papier-Filter abgetrennt.

Die so erhaltene Lösung kann nochmals destillativ von ihren flüchtigen Bestandteilen befreit werden und anschließend mit einem $C_1$- bis $C_4$-Alkohol auf den gewünschten Feststoffgehalt eingestellt werden.

Die erfindungsgemäßen Aminoharz-Lösungen sind mit Methanol unbegrenzt und mit Wasser mindestens im Verhältnis 1 : 1,5, bevorzugt 1 : ∞ mischbar. Die elektrische Leitfähigkeit ist < 100 µS/cm, bevorzugt < 50 µS/cm, besonders bevorzugt < 20 µS/cm.

Diese Aminoharz-Lösungen eignen sich zum Imprägnieren von Fasermaterial auf Basis von Cellulose, Glas oder synthetischen Polymeren wie Polyethylen, Polypropylen, Polyamid, Polyester. Zur Imprägnierung können die Aminoharz-Lösungen mit und ohne Härter verwendet werden.

Geeignete Härter sind beispielsweise Ameisensäure, Maleinsäure und Paratoluolsulfonsäure.

Die Substrate werden mit 20 bis 120, bevorzugt 80 bis 100 Gew.% Festharz, bezogen auf das Substratgewicht, getränkt. Die Trocknung der Imprägnate erfolgt beispielsweise in Schlitzdüsenschwebetrocknern bei Lufttemperaturen von 120 bis 180°C, bevorzugt 140 bis 160°C.

Die erfindungsgemäßen Aminoharz-Lösungen können auch in zwei aufeinanderfolgenden Imprägnierschritten auf das Substrat aufgebracht werden. So ist es möglich, vor bzw. nach einer Beharzung mit den erfindungsgemäßen Produkten übliche Phenol-Formaldehyd-Kondensate auf das Substrat aufzubringen oder diese Mischungen miteinander zu verarbeiten.

Nun werden mehrere Schichten des imprägnierten und vorgetrockneten Imprägnates zu einem Schichtpreßstoff bei Temperaturen von etwa 130 bis 180°C, bevorzugt 150 bis 170°C und Drücken von 7 bis 18 N/mm², bevorzugt 8 bis 10 N/mm² in Etagen-Pressen verpreßt.

Diese Schichtpreßstoffe weisen einen spezifischen Durchgangswiderstand nach DIN 53 482 von $10^8$ bis $10^{12}$ Ω • cm, bevorzugt $10^{10}$ bis $11^{11}$ Ω • cm und einem Flächenoberwiderstand nach DIN 53 482 von $10^9$ bis $10^{12}$ Ω, bevorzugt $10^{10}$ bis $10^{11}$ Ω auf. Dabei beträgt die Wasseraufnahme des Schichtpreßstoffes nach DIN 40 802 maximal 40, bevorzugt 20 - 30 mg.

Bevorzugt werden mit den erfindungsgemäßen Aminoharz-Lösungen cellulosische Substrate wie Papier

3

getränkt. Die daraus hergestellten Schichtpreßstoffe sind hochelastisch und stanzbar und verhalten sich im Brandtest normgerecht. Sie sind hervorragend zur Herstellung von elektrischen Leitertafeln geeignet.

Beispiel 1

In einem Reaktionsgefäß wurden 357 g 40 gew.%iger wäßriger Formaldehyd mit 1 g Triethanolamin auf einen pH-Wert von 7,2 eingestellt. Nach Zugabe von 150 g Melamin (Molverhältnis Melamin (M) : Formaldehyd (F) = 1 : 4) wurde das Reaktionsgemisch auf 90°C aufgeheizt, 5 min bei 90°C gehalten und auf 65°C abgekühlt. Das erhaltene Methylolierprodukt wurde anschließend mit 600 g Methanol verdünnt, mit 5,3 g Oxalsäure auf einen pH-Wert von 4,2 eingestellt und 45 min bei 50°C verethert. Durch Zugabe von 13,7 g 25-gew.%iger Natronlauge wurde die Veretherungsreaktion beendet. Überschüssiges Methanol wurde zunächst bei Normaldruck, danach im Vakuum bei einem Druck von 50 - 100 mbar abdestilliert. Das so erhaltene Harz wurde noch einmal mit 240 g Methanol verdünnt und das überschüssige Methanol wiederum zunächst bei Normaldruck bis 90°C und danach im Vakuum bis 60°C abdestilliert.

Anschließend wurde das Harz mit 120 g Methanol verdünnt und filtriert.

Man erhielt 340 g einer erfindungsgemäßen Harzlösung mit nachstehenden Analysendaten:

| Nichtflüchtige Anteile (2 g, 2 h, 125°C) | 65,2 Gew.% |
|---|---|
| Wassergehalt | 4,38 Gew.% |
| Wasserverträglichkeit | 1 : unendlich |
| elektrische Leitfähigkeit | 19 Mikrosiemens |

Beispiel 2

In einem Reaktionsgefäß wurden 36 kg 40 gew.%ige wäßrige Formaldehydlösung mit 100 g Triethanolamin versetzt, wodurch sich ein pH-Wert von 7,2 einstellte. Dieser Lösung wurden 15 kg Melamin zugesetzt, die anschließend durch Aufheizen auf 90°C und Einhalten dieser Temperatur über 5 min methyloliert wurden. Nach Abkühlen auf 65°C erfolgte der Zusatz von 60 kg Methanol und 500 g Oxalsäure. Die Veretherung wurde innerhalb von 45 min bei 50°C und einem pH-Wert von 4,3 durchgeführt und durch Zugabe von 1 340 g 25 gew.%iger Natronlauge abgestoppt. Überschüssiges Methanol wurde zunächst bei Normaldruck bis 90°C und danach unter Vakuum abdestilliert. Das so erhaltene Harz wurde noch einmal mit 24 kg Methanol verdünnt und wie oben beschrieben auch wieder aufkonzentriert. Abschließend wurde das Harz mit 12 kg Methanol verdünnt und filtriert.

Man erhielt 34 kg einer erfindungsgemäßen Harzlösung mit nachstehenden Analysendaten:

| Nichtflüchtige Anteile | 68,1 Gew.% |
|---|---|
| Viskosität | 0,2 Pa.s |
| Wassergehalt | 2,9 Gew.% |
| Wasserverträglichkeit | 1 : unendlich |
| elektrische Leitfähigkeit | 18 Mikrosiemens |

Beispiel 3

In einem Reaktionsgefäß wurden 363 g 40 gew.%iger wäßriger Formaldehyd mit 0,9 g Triethanolamin auf einen pH-Wert von 7,0 eingestellt. Nach Zugabe von 150 g Melamin (Molverhältnis M : F = 1 : 4,07) wurde das Reaktionsgemisch auf 90°C aufgeheizt, 5 min bei 90°C gehalten und danach auf 75°C abgekühlt. Das so erhaltene mehrfach methylolierte Melamin wurde nach Zugabe von 600 g Methanol und 5 g Citronensäure bei einem pH-Wert von 4,5 und einer Temperatur von 50°C 45 min verethert. Durch Zugabe von 12 g 25 gew.%iger Natronlauge wurde die Veretherung abgebrochen und überschüssiges Methanol zunächst unter Normaldruck bis zu einer Temperatur von 90°C und dann nach Abkühlung unter Vakuum bis zu einer Tempertur von 36°C abdestilliert. Das so erhaltene trübe Harz wurde noch einmal mit 240 g Methanol verdünnt und der Alkohol wiederum zunächst unter Normaldruck bis zu einer Temperatur von 90°C und anschließend unter Vakuum bis zu einer Temperatur von 50°C abdestilliert.

Das so erhaltene Harz wurde mit 150 g Methanol verdünnt.

Man erhielt 365 g einer erfindungsgemäßen Harzlösung mit nachstehenden Analysendaten:

| | |
|---|---|
| Nichtflüchtige Anteile (2 g, 2 h, 125°C ) | 60,3 Gew.% |
| Viskosität | 100 mPa.s |
| Wassergehalt | 5,5 Gew.% |
| Wasserverträglichkeit | 1 : unendlich |
| elektrische Leitfähigkeit | 24 Mikrosiemens |

Beispiel 4

In einem Reaktionsgefäß wurden 357 g 40 %iger wäßriger Formaldehyd mit 4 g Hexamethylentetramin auf einem pH-Wert von 7,0 eingestellt. Nach Zugabe von 150 g Melamin (Molverhältnis M : F = 1 : 4) wurde das Reaktionsgemisch auf 90°C aufgeheizt, 5 min bei 90°C gehalten und auf 65°C abgekühlt. Das erhaltene Methylolierprodukt wurde anschließend mit 600 g Methanol verdünnt, mit 5,3 g Oxalsäure auf einem pH-Wert von 4,5 eingestellt und 45 min bei 50°C verethert. Durch Zugabe von 13,7 g 25 gew.%iger Natronlauge wurde die Veretherung abgebrochen. Überschüssiges Methanol wurde zunächst bei Normaldruck, danach im Vakuum abdestilliert. Das so erhaltene Harz wurde noch einmal mit 240 g Methanol verdünnt und das überschüssige Methanol zunächst bei Normaldruck bis 90°C und danach im Vakuum bis 50°C abdestilliert. Anschließend wurde das Harz mit 120 g Methanol verdünnt.

Man erhielt 340 g einer erfindungsgemäßen Harzlösung mit nachstehenden Analysendaten:

| | |
|---|---|
| Nichtflüchtige Anteile (2 g, 2 h, 125°C ) | 64,4 Gew.% |
| Wassergehalt | 6,0 Gew.% |
| Wasserverträglichkeit | 1 : unendlich |
| elektrische Leitfähigkeit | 11 Mikrosiemens |

Beispiel 5

In einem Reaktionsgefäß wurden 363 g 40 %iger wäßriger Formaldehyd und 0,9 g Triethanolamin auf einen pH-Wert von 7,0 eingestellt. Dieser Lösung wurden 150 g Melamin zugesetzt (Molverhältnis M : F = 1 : 4,07), die sofort durch Aufheizen auf 90°C und Einhalten dieser Temperatur über 5 min methyloliert wurden. Nach Abkühlen der Reaktionslösung auf 75°C erfolgte die Zugabe von 600 g Methanol und 5 g Malonsäure. Die Veretherung wurde innerhalb von 45 min bei 50°C und einem pH-Wert von 4,2 durchgeführt und durch Zugabe von 15 g 25 gew.%iger Natronlauge abgebrochen. Überschüssiges Methanol wurde nun zunächst unter Normaldruck bis zu einer Temperatur von 90°C und anschließend unter Vakuum bis zu einer Temperatur von 36°C abdestilliert. Die so erhaltene trübe Harzlösung wurde nochmals mit 240 g Methanol verdünnt und wie oben beschrieben aufkonzentriert. Durch Verdünnen mit 80 g Methanol erhielt man die gewünschte Viskosität.

Man erhielt 300 g einer erfindungsgemäßen Harzlösung mit nachstehenden Analysendaten:

| Nichtflüchtige Anteile (2 g, 2 h, 125° C ) | 63,5 Gew.% |
|---|---|
| Viskosität | 100 mPa.s |
| Wassergehalt | 5,2 Gew.% |
| Wasserverträglichkeit | 1 : unendlich |
| elektrische Leitfähigkeit | 32 Mikrosiemens |

Beispiel 6

Herstellung eines Schichtstoffes

Durch Tauchimprägnierung wurden mit der Harzlösung aus Beispiel 1 elektrolytfreie Natroncellulose mit 120 $g/m^2$ beharzt. Die Papierbahn wurde mit fallenden Temperaturen von 160 bis 140° C in einem Schwebetrockner auf eine Restfeuchte von etwa 3 Gew.-% getrocknet. Das Filmendgewicht betrug 245 $g/m^2$. Die so erhaltene Filmbahn wurde dann auf ein Format von 50 x 50 cm zugeschnitten. Für die Verdichtung wurden 8 solcher Lagen in einer Presse bei 8 $N/mm^2$ bei 160° C Objekttemperatur zu einem Laminat verpreßt. Es wurden folgende Eigenschaftswerte ermittelt.

| Eigenschaften | |
|---|---|
| Spezifischer Durchgangswiderstand [$\Omega$ • cm] in NK 23/50 DIN 53482 | $1,0 • 10^{11}$ |
| Oberflächenwiderstand [$\Omega$] in NK 23/50 DIN 53482 | $1,0 • 10^{10}$ |
| Wasseraufnahme [mg] DIN 40802 | 30 |

## Ansprüche

1. Aminoharz-Lösungen mit einer elektrischen Leitfähigkeit < 100 $\mu$S/cm zum Imprägnieren von Papier, erhältlich durch

A) Methylolierung von Melamin mit wäßrigem Formaldehyd im Molverhältnis 1 : 2 bis 5 in Gegenwart eines tertiären organischen Amins bei einem pH-Wert von 7 bis 12

B) Veretherung mit einem molaren Überschuß, bezogen auf die Methylolgruppen, eines $C_1$- bis $C_4$-Alkohols in Gegenwart einer substituierten oder unsubstituierten organischen Dicarbonsäure und/oder Polycarbonsäure bei einem pH-Wert von 3 bis 6

C) Neutralisation des Reaktionsgemisches mit einer anorganischen Base und Abdestillation der flüchtigen Bestandteile bis auf einen Wassergehalt von < 10 Gew.%, bezogen auf das Reaktionsgemisch,

D) Zugabe eines $C_1$- bis $C_4$-Alkohols bis zu einem Feststoffgehalt, bezogen auf Aminoharz-Lösungen, von 40 bis 90 Gew.% und Entfernen von unlöslichen Bestandteilen durch Filtration.

2. Aminoharz-Lösungen nach Anspruch 1, erhältlich unter Verwendung von Methanol als Alkohol bei der Veretherung (B).

3. Aminoharz-Lösungen nach Anspruch 1 oder 2, erhältlich unter Verwendung aliphatischer $C_2$- bis $C_7$-Dicarbonsäuren bei der Veretherung (B).

4. Aminoharz-Lösungen nach einem der Ansprüche 1 bis 3, erhältlich unter Verwendung von Oxalsäure, Malonsäure oder Bernsteinsäure als Dicarbonsäuren bei der Veretherung (B).

5. Aminoharz-Lösungen nach einem der Ansprüche 1 bis 4, erhältlich unter Verwendung von Hydroxibernsteinsäure oder Weinsäure als substituierte Dicarbonsäuren bei der Veretherung (B).

6. Aminoharz-Lösungen nach einem der Ansprüche 1 bis 5, erhältlich unter Verwendung von Citronensäure als Polycarbonsäure bei der Veretherung (B).

7. Verwendung der Aminoharz-Lösungen gemäß einem der Ansprüche 1 bis 6 zum Imprägnieren von Fasermaterial auf Basis von Cellulose, Glas oder synthetischen Polymeren.

8. Verwendung der Aminoharz-Lösungen gemäß einem der Ansprüche 1 bis 6 zur Herstellung von Schichtpreßstoffen.

9. Schichtpreßstoffe, erhältlich unter Verwendung der Aminoharz-Lösungen gemäß einem der Ansprüche 1 bis 6.

10. Verwendung der Schichtpreßstoffe gemäß Anspruch 9 zur Herstellung von elektrischen Leitertafeln.

11. Elektrische Leitertafeln erhältlich unter Verwendung der Schichtpreßstoffe gemäß Anspruch 9.

Patentansprüche für folgenden Vertragsstaat: ES

1. Verfahren zur Herstellung von Aminoharz-Lösungen mit einer elektrischen Leitfähigkeit < 100 $\mu$S/cm zum Imprägnieren von Papier, dadurch gekennzeichnet, daß man

A) Melamin mit wäßrigem Formaldehyd im Molverhältnis 1 : 2 bis 5 in Gegenwart eines tertiären organischen Amins bei einem pH-Wert von 7 bis 12 methyloliert,

B) mit einem molaren Überschuß, bezogen auf die Methylolgruppen, eines $C_1$- bis $C_4$-Alkohols in Gegenwart einer substituierten oder unsubstituierten organischen Dicarbonsäure und/oder Polycarbonsäure bei einem pH-Wert von 3 bis 6 verethert, und

C) das Reaktionsgemisch mit einer anorganischen Base neutralisiert und die flüchtigen Bestandteile bis auf einen Wassergehalt von < 10 Gew.%, bezogen auf das Reaktionsgemisch, abdestilliert und

D) nach Zugabe eines $C_1$- bis $C_4$-Alkohols bis zu einem Feststoffgehalt, bezogen auf Aminoharz-Lösungen, von 40 bis 90 Gew.% die unlöslichen Bestandteile durch Filtration entfernt.

2. Verfahren zur Herstellung von Aminoharz-Lösungen nach Anspruch 1, dadurch gekennzeichnet, daß man bei der Veretherung (B) Methanol als Alkohol verwendet.

3. Verfahren zur Herstellung von Aminoharz-Lösungen nach Anspruch 1 oder 2, dadurch gekennzeichnet, daß man bei der Veretherung (B) aliphatische $C_2$- bis $C_7$-Dicarbonsäuren verwendet.

4. Verfahren zur Herstellung von Aminoharz-Lösungen nach einem der Ansprüche 1 bis 3, dadurch gekennzeichnet, daß man Oxalsäure, Malonsäure oder Bernsteinsäure als Dicarbonsäuren verwendet.

5. Verfahren zur Herstellung von Aminoharz-Lösungen nach einem der Ansprüche 1 bis 4, dadurch gekennzeichnet, daß man Hydroxibernsteinsäure oder Weinsäure als substituierte Dicarbonsäuren verwendet.

6. Verfahren zur Herstellung von Aminoharz-Lösungen nach einem der Ansprüche 1 bis 5, dadurch gekennzeichnet, daß man bei der Veretherung (B) Citronensäure als Polycarbonsäure verwendet.

7. Verfahren zum Imprägnieren von Fasermaterial auf Basis von Cellulose, Glas oder synthetischen Polymeren, dadurch gekennzeichnet, daß man Aminoharzlösungen gemäß einem der Ansprüche 1 bis 6 verwendet.

8. Verfahren zur Herstellung von Schichtpreßstoffen, dadurch gekennzeichnet, daß man Aminoharz-Lösungen gemäß einem der Ansprüche 1 bis 6 verwendet.

9. Verfahren zur Herstellung von elektrischen Leitertafeln, dadurch gekennzeichnet, daß man Schichtpreßstoffe gemäß Anspruch 8 verwendet.